# EUROPEAN PATENT APPLICATION

(11) **EP 4 761 524 A1**
(43) Date of publication of application: **17.06.2026**
(21) Application number: 25178356.9
(22) Date of filing: 22.05.2025
(51) Int. Cl.: H10F 19/90, H10F 77/20

(54) **BACK CONTACT PHOTOVOLTAIC MODULE**

(30) Priority: 12.12.2024 CN 202411838243
(71) Applicant: JINKO SOLAR CO., LTD, ShangRao, Jiangxi 334100 (CN); Jinko Solar (Haining) Co., Ltd., Jiaxing City, Zhejiang (CN)
(72) Inventor: TAO, Wusong, Jiangxi, 334100 (CN); WANG, Luchuang, Jiangxi, 334100 (CN); PENG, Yingying, Jiangxi, 334100 (CN); FANG, Sheng, Jiangxi, 334100 (CN)
(74) Representative: Balder IP Law, S.L.

(57) **Abstract**

Embodiments of the present disclosure relate to the technical field of photovoltaic technology and provide a back contact photovoltaic module, which can at least improve efficiency of the back contact photovoltaic module. The back contact photovoltaic module includes: solar cells each including a first surface, a plurality of bus bars and a plurality of finger electrodes formed on the first surface, and insulation portions arranged on the first surface. The plurality of finger electrodes includes first finger electrodes and second finger electrodes extending along a first direction and alternatingly arranged along a second direction. The plurality of bus bars includes first bus bars and second bus bars extending along the second direction and alternatingly arranged along the first direction. Each bus bar includes a respective main body and respective welding portions formed at intervals on the respective main body. The insulation portions are configured to cover ends of the first finger electrodes and ends of the second finger electrodes, the insulation portions includes first insulation portions and second insulation portions, the first insulation portions are respectively arranged on opposing sides of the respective main body in the first direction and are respectively arranged adjacent to the respective welding portions in the second direction, and the second insulation portions are respectively arranged on opposing sides of the respective main body in the first direction. In the first direction, two first insulation portions are spaced apart by a first distance, and two second insulation portions are spaced apart by a second distance that is greater than the first distance.

## Description

### TECHNICAL FIELD

Embodiments of the present disclosure relate to the technical field of photovoltaic technology, and in particular to a back contact photovoltaic module.

### BACKGROUND

At present, with the gradual depletion of fossil energy, solar cells are used more and more widely as a new energy alternative. The solar cell is a device for converting solar light energy into electric energy. The solar cell generates carriers by using the photovoltaic principle, and carriers are led out by electrodes, thereby effectively utilizing the electric energy.

The IBC (Interdigitated Back Contact) cell refers to a back-contact solar cell structure with back junctions, in this structure, the front and back metal electrodes are arranged in an interdigital manner on the back surface of the solar cell. A back junction refers to a p-n junction formed on the back surface of the solar cell.

The IBC cell is one of the photovoltaic cells with the highest conversion efficiency at present. A substrate of the IBC cell is made of monocrystalline silicon, p-n junctions and metal electrodes are all formed on the back surface of the solar cell, and the front surface is free of metal electrodes shading, so that a very high short-circuit current and conversion efficiency can be achieved. However, in the process of manufacturing the IBC cell, there are still many reasons for affecting the performance of the IBC cell, thereby limiting the further improvement of the photoelectric conversion efficiency of the IBC cell.

### SUMMARY

Embodiments of the present disclosure provide a back contact photovoltaic module, which is at least conducive to improvement of efficiency of the back contact photovoltaic module.

Some embodiments of the present disclosure provide a back contact photovoltaic module, including: solar cells, where one respective solar cell of the solar cells includes a first surface, a plurality of bus bars and a plurality of finger electrodes formed on the first surface; and insulation portions arranged on the first surface. The plurality of finger electrodes include first finger electrodes and second finger electrodes extending along a first direction and alternatingly arranged along a second direction, the first direction intersecting the second direction, and the first finger electrodes are of a polarity that is different from a polarity of the second finger electrodes. The plurality of bus bars include first bus bars and second bus bars extending along the second direction and alternatingly arranged along the first direction, each first bus bar of the first bus bars is in electrical contact with a respective plurality of first finger electrodes of the first finger electrodes, and each second bus bar of the second bus bars is in electrical contact with a respective plurality of second finger electrodes of the second finger electrodes. Each bus bar of the plurality of bus bars includes a respective main body extending along the second direction and respective welding portions formed at intervals on the respective main body, and each welding portion of the respective welding portions has a dimension larger than a dimension of the respective main body in the first direction. The insulation portions are configured to cover at least ends of the first finger electrodes facing any of the second bus bars and ends of the second finger electrodes facing any of the first bus bars, the insulation portions includes first insulation portions and second insulation portions, the first insulation portions are respectively arranged on opposing sides of the main body of a respective bus bar in the first direction, and are respectively arranged to adjacent to the welding portions of the respective bus bar in the second direction, and the second insulation portions are respectively arranged on opposing sides of the main body of the respective bus bar and space apart from the main body of the respective bus bar in the first direction. In the first direction, two first insulation portions of the first insulation portions respectively arranged on opposing sides of the main body of the respective bus bar are spaced apart by a first distance, and two second insulation portions of the second insulation portions respectively arranged on opposing sides of the main body of the respective bus bar are spaced apart by a second distance that is greater than the first distance.

In some embodiments, a respective plurality of pairs of second insulation portions directly facing to each other are arranged between every two adjacent welding portions of the welding portions of the respective bus bar along the second direction, each pair of second insulation portions of the respective plurality of pairs of second insulation portions are configured to respectively cover two respective finger electrodes of the plurality of finger electrodes, and ends of the respective plurality of pairs of second insulation portions form an ellipse-like space that tapers along the second direction.

In some embodiments, the welding portions of the respective bus bar include two outermost welding portions, a respective plurality of pairs of second insulation portions directly facing to each other are arranged between each welding portion of the two outermost welding portions and a corresponding edge of the respective solar cell along the second direction, each pair of second insulation portions of the respective plurality of pairs of second insulation portions are configured to respectively cover two respective finger electrodes of the plurality of finger electrodes, and a distance between one respective pair of second insulation portions of the respective plurality of pairs of second insulation portions along the first direction gradually increases with a distance between the respective pair of second insulation portions and any one of the two outermost welding portions along the second direction.

In some embodiments, the insulation portions further include third insulation portions respectively arranged on opposing sides of the welding portions of the respective bus bar in the first direction, and in the first direction, one respective third insulation portion of the third insulation portions and a corresponding welding portion of the welding portions of the respective bus bar are spaced apart by a distance larger than a distance between one respective first insulation portion of the first insulation portions and the main body of the respective bus bar.

In some embodiments, the insulation portions further include third insulation portions respectively arranged on opposing sides of the welding portions of the respective bus bar in the first direction, and in the second direction, one respective third insulation portion of the third insulation portions and a finger electrode adjacent to the respective third insulation portion are spaced apart by a distance greater than a distance between one respective first insulation portion of the first insulation portions and a finger electrode adjacent to the respective first insulation portion.

In some embodiments, in the second direction, one respective first insulation portion of the first insulation portions and a finger electrode adjacent to the respective first insulation portion are spaced apart by a distance greater than a distance between one respective second insulation portion of the second insulation portions and a finger electrode adjacent to the respective second insulation portion.

In some embodiments, the insulation portions further include third insulation portions respectively arranged on opposing sides of the welding portions of the respective bus bar in the first direction, and an end of one respective first insulation portion of the first insulation portions facing the main body of the respective bus bar and an end of a finger electrode covered by the respective first insulation portion are spaced apart by a distance greater than a distance between an end of one respective third insulation portion of the third insulation portions facing a corresponding welding portion and an end of a finger electrode covered by the respective third insulation portion.

In some embodiments, each insulation portion of the insulation portions includes a respective body portion and a respective widened portion connected to each other, widened portions are configured to cover ends of the plurality of finger electrodes, and the respective body portion is arranged on a side of the respective widened portion away from an end of a finger electrode covered by the respective widened portion. A width of the respective widened portion along the second direction is greater than a width of the respective body portion along the second direction.

In some embodiments, the insulation portions further include third insulation portions respectively arranged on opposing sides of the welding portions of the respective bus bar in the first direction, and a widened portion of one respective third insulation portion of the third insulation portions along the first direction has a length less than a length of a widened portion of one respective first insulation portion of the first insulation portions.

In some embodiments, the back contact photovoltaic module further includes welding strips configured for connecting the solar cells. Each welding strip of the welding strips is arranged on a respective bus bar of the plurality of bus bars and is welded with welding portions of the respective bus bar, and in the first direction, a ratio of the first distance to a width of a corresponding welding strip of the welding strips is in a range of 0.9 to 1.1.

The technical solutions provided in the embodiments of the present disclosure have the beneficial effects as follows.

In the back contact photovoltaic module provided in the embodiments of the present disclosure, a plurality of bus bars and a plurality of finger electrodes are formed on the surface of one respective solar cell, the plurality of finger electrodes includes first finger electrodes and second finger electrodes, and the first finger electrodes are of a polarity that is different from a polarity of the second finger electrodes. The first finger electrodes can collect one of electrons or holes in the respective solar cell, and the second finger electrodes can collect the other of electrons or holes in the respective solar cell. The plurality of bus bars includes first bus bars and second bus bars, each first bus bar is in electrical contact with a respective plurality of first finger electrodes of the first finger electrodes, and each second bus bar is in electrical contact with a respective plurality of second finger electrodes of the second finger electrodes. In this way, the first bus bars can collect the carriers collected by the first finger electrodes arranged along the second direction, and the second bus bars can collect the carriers collected by the second finger electrodes arranged along the second direction. Each bus bar includes a respective main body and respective welding portions formed at intervals on the respective main body, and each welding portion has a dimension larger than a dimension of the respective main body in the first direction. In this way, when arranging a respective welding strip on each bus bar, the respective welding portions can have larger contact areas with the respective welding strip compared to the respective main body, thereby improving the welding stability between each bus bar and the respective welding strip. The insulation portions are configured to cover ends of the first finger electrodes facing any of the second bus bars and ends of the second finger electrodes facing any of the first bus bars. The insulation portions can prevent the finger electrodes that are arranged on both sides of a bus bar, not in connection with the bus bar, and of a polarity different from that of the bus bar from connecting with the corresponding welding strip and prevent the resulted short-circuit, which is conducive to improvement of the stability of the back contact photovoltaic module. The insulation portions includes first insulation portions and second insulation portions, the first insulation portions are respectively arranged on opposing sides of the main body of a respective bus bar in the first direction, and are respectively arranged to adjacent to the welding portions of the respective bus bar in the second direction, and the second insulation portions are respectively arranged on opposing sides of the main body of the respective bus bar and space apart from the main body of the respective bus bar in the first direction. In the first direction, two first insulation portions of the first insulation portions respectively arranged on opposing sides of the main body of the respective bus bar are spaced apart by a first distance, and two second insulation portions of the second insulation portions respectively arranged on opposing sides of the main body of the respective bus bar are spaced apart by a second distance that is greater than the first distance. In this way, the distance between two first insulation portions along the first direction is relatively small, such that the respective welding strip can fit in between the first insulation portions along the second direction, thereby preventing the welding misalignment caused by offset of the respective welding strip during or after the welding. The distance between two second insulation portions along the first direction is relatively large, in this way, the second insulation portions are not prone to move and cover the respective main body, resulting in failure in contact between the respective welding strip and the respective main body, thereby improving the contact reliability between the respective welding strip and the respective main body. The back contact photovoltaic module provided in the embodiments of the present disclosure can, on the one hand, improve the welding stability between the respective welding strip and the respective welding portions, and on the other hand, it can improve the contact reliability between the respective welding strip and the respective main body. In this way, the carrier transport efficiency can be comprehensively improved, power loss can be reduced, and the overall efficiency of the back contact photovoltaic module can be improved.

### BRIEF DESCRIPTION OF THE DRAWINGS

Exemplary illustrations of one or more embodiments are provided by reference to pictures in the corresponding accompanying drawings. These exemplary illustrations do not constitute a limitation on the embodiments. The drawings do not constitute a scale limitation unless otherwise specified. In order to illustrate the technical solutions in related technologies or in the embodiments of the present disclosure more clearly, the drawings to be used in the embodiments will be briefly described below. It is obvious that the drawings mentioned in the following illustration are only some embodiments of the present disclosure. For those of ordinary skill in the art, other drawings may also be obtained in accordance with these drawings without any inventive effort.
FIG. 1 is a top view of a solar cell of the back contact photovoltaic module according to some embodiments of the present disclosure;
FIG. 2 is a schematic enlarged view of a local structure denoted by the dashed box A in FIG. 1; and
FIGS. 3 to 5 are schematic enlarged views of local structures of a plurality of solar cells according to some embodiments of the present disclosure.

### DETAILED DESCRIPTION OF THE EMBODIMENTS

As known from the background, in the process of manufacturing the IBC cells, there are still many reasons for affecting the performance of the IBC cells, thereby limiting the further improvement of the photoelectric conversion efficiency of the IBC cells.

The back contact photovoltaic module provided in the embodiments of the present disclosure can, on the one hand, improve the welding stability between the respective welding strip and the respective welding portions, and on the other hand, it can improve the contact reliability between the respective welding strip and the respective main body. In this way, the carrier transport efficiency can be comprehensively improved, power loss can be reduced, and the overall efficiency of the back contact photovoltaic module can be improved.

In the description of the embodiments of the present disclosure, the technical terms "first", "second", and the like are merely intended to distinguish different objects, and shall not be understood as an indication or implication of relative importance or implicit indication of the number, specific sequence, or dominant-subordinate relationship of the technical features indicated.

In the description of the embodiments of the present disclosure, "a plurality of" means two or more, unless otherwise specifically stated.

The term "embodiment" described herein means that specific features, structures, or characteristics described in combination with the embodiments may be incorporated in at least one embodiment of the present disclosure. Phrases appearing at various positions of the specification refer to neither the same embodiment nor separate or alternative embodiments that are mutually exclusive with other embodiments. It is explicitly and implicitly understood by those skilled in the art that the embodiments described herein may be combined with other embodiments.

In the description of the embodiments of the present disclosure, the term "and/or" herein is merely an association relationship describing associated objects, indicating that three relationships may exist. For example, A and/or B indicates that there are three cases of A alone, A and B together, and B alone. In addition, the character "/" herein generally indicates an "or" relationship between the associated objects.

In the description of the embodiments of the present disclosure, the orientation or position relationships indicated by the technical terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", and the like are based on the orientation or position relationships shown in the accompanying drawings and are intended to facilitate the description of the present disclosure and simplify the description only, rather than indicating or implying that the apparatus or element referred to must have a particular orientation or be constructed and operated in a particular orientation, and therefore are not to be interpreted as limiting the embodiments of the present disclosure.

In the illustration of the embodiments of the present disclosure, unless otherwise specified and limited, technical terms such as "installation", "coupling", "connection", or "fixation" should be broadly understood. For example, "connection" may refer to fixed connections, detachable connections, integrated as a whole, mechanical connections or electrical connections, direct connections or indirect connections through an intermediate medium, or internal connections between two components or an interaction relationship between two components. For those skilled in the art, the specific meanings of the above terms in the embodiments of the present disclosure shall be understood according to the specific situations.

In the drawings corresponding to the embodiments of the present disclosure, for better understanding and ease of description, a thickness and an area of a layer are exaggerated. When a component is described as being on the other component or on a surface of the other component, the component may be "directly" on the surface of the other component or there may be a third component between the two components. In contrast, when one component is described as being at the surface of the other component or the other component is formed at or provided at a surface of one component, there is no third component between the two components. In addition, when a component is described as being "substantially" formed on the other component, it means that the component is neither formed on the entire surface (or a front surface) of the other component, nor formed on part of an edge of the entire surface.

In the description of the embodiments of the present disclosure, when a component "includes" another component, other components are not excluded and may further be included unless otherwise stated.

The terms used in the description of the embodiments herein are for describing particular embodiments only and not intended to be limiting. As used in the description of the embodiments described and in the appended claims, "component" is also intended to include the plural form unless the context clearly indicates otherwise.

Various embodiments of the present disclosure will be described in detail below with reference to the accompanying drawings. However, those of ordinary skill in the art shall understand that in the embodiments of the present disclosure, many technical details are provided to enable readers to better understand the embodiments of the present disclosure. However, even without these technical details and various changes and modifications based on the following embodiments, the technical solutions claimed in the embodiments of the present disclosure can still be implemented.

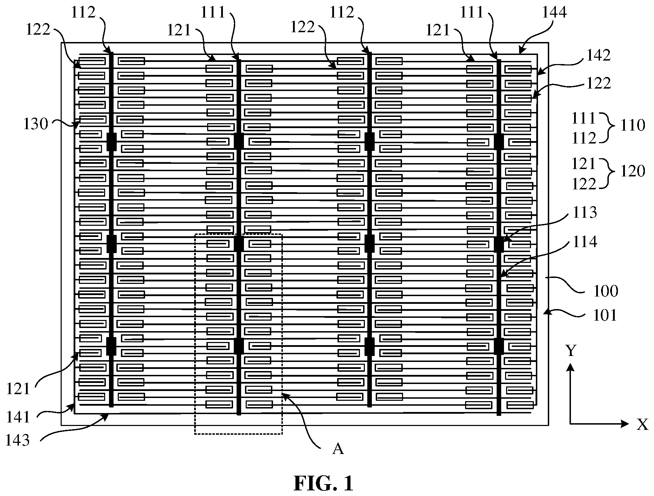

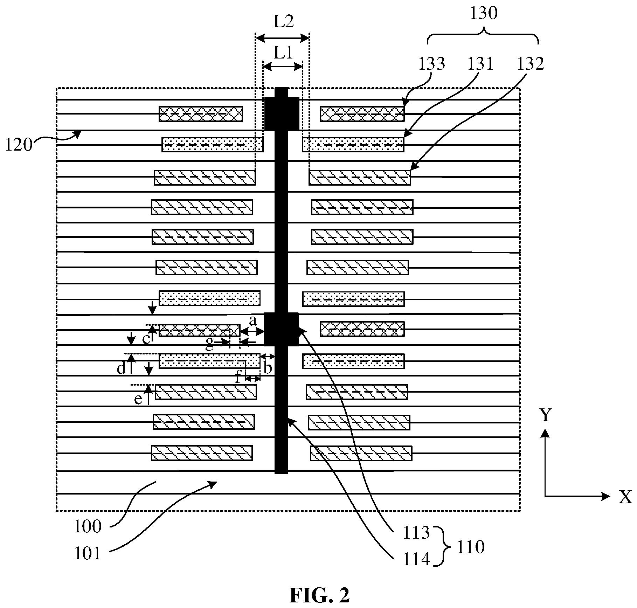

FIG. 1 is a top view of a solar cell of the back contact photovoltaic module according to some embodiments of the present disclosure. FIG. 2 is a schematic enlarged view of a local structure denoted by the dashed box A in FIG. 1. The insulation portions 130 shown in FIG. 1 are assumed to be transparent.

Referring to FIGS. 1 and 2, the back contact photovoltaic module provided in some embodiments of the present disclosure includes: solar cells 100, where one respective solar cell of the solar cells 100 includes a first surface 101; and insulation portions 130 arranged on the first surface 101. A plurality of bus bars 110 and a plurality of finger electrodes 120 are formed on the first surface 101. The plurality of finger electrodes 120 include first finger electrodes 121 and second finger electrodes 122 extending along a first direction X and alternatingly arranged along a second direction Y, the first direction X intersecting the second direction Y, and the first finger electrodes 121 are of a polarity that is different from a polarity of the second finger electrodes 122. The plurality of bus bars 110 includes first bus bars 111 and second bus bars 112 extending along the second direction Y and alternatingly arranged along the first direction X, each first bus bar of the first bus bars 111 is in electrical contact with a respective plurality of first finger electrodes of the first finger electrodes 121, and each second bus bar of the second bus bars 112 is in electrical contact with a respective plurality of second finger electrodes of the second finger electrodes 122. Each bus bar of the plurality of bus bars 110 includes a respective main body 114 and respective welding portions 113 formed at intervals on the respective main body, the respective main body 114 extends along the second direction Y, and each welding portion of the respective welding portions 113 has a dimension larger than a dimension of the respective main body 114 along the first direction X. The insulation portions 130 are configured to cover at least ends of the first finger electrodes 121 facing any of the second bus bars 112 and ends of the second finger electrodes 122 facing any of the first bus bars 111. The insulation portions 130 includes first insulation portions 131 and second insulation portions 132, the first insulation portions 131 are respectively arranged on opposing sides of the respective main body 114 along the first direction X, space apart from the respective main body 114, and are respectively arranged to adjacent to the welding portions 113 of the respective bus bar 110 in the second direction Y, and the second insulation portions 132 are respectively arranged on opposing sides of the respective main body 114 along the first direction X and space apart from the respective main body 114. In the first direction X, a first distance L1 between two first insulation portions of the first insulation portions 131 respectively arranged on opposing sides of the respective main body 114 is smaller than a second distance L2 between two second insulation portions of the second insulation portions 132 respectively arranged on opposing sides of the respective main body 114.

In the back contact photovoltaic module provided in the embodiments of the present disclosure, a plurality of bus bars 110 and a plurality of finger electrodes 120 are formed on the surface of one respective solar cell 100, the plurality of finger electrodes 120 includes first finger electrodes 121 and second finger electrodes 122, and a polarity of the first finger electrodes 121 is different from a polarity of the second finger electrodes 122. The first finger electrodes 121 can collect one of electrons or holes in the respective solar cell 100, and the second finger electrodes 122 can collect the other of electrons or holes in the respective solar cell 100. The plurality of bus bars 110 includes first bus bars 111 and second bus bars 112, each first bus bar 111 is in electrical contact with a respective plurality of first finger electrodes of the first finger electrodes 121, and each second bus bar 112 is in electrical contact with a respective plurality of second finger electrodes of the second finger electrodes 122. In this way, the first bus bars 111 can collect the carriers collected by the first finger electrodes 121 arranged along the second direction Y, and the second bus bars 112 can collect the carriers collected by the second finger electrodes 122 arranged along the second direction Y. Each bus bar 110 includes a respective main body 114 and respective welding portions 113 formed at intervals on the respective main body, and each welding portion 113 has a dimension larger than a dimension of the respective main body 114 along the first direction X. In this way, when arranging a respective welding strip on each bus bar 110, the respective welding portions 113 can have larger contact areas with the respective welding strip compared to the respective main body 114, thereby improving the welding stability between each bus bar 110 and the respective welding strip. The insulation portions 130 are configured to cover ends of the first finger electrodes 121 facing any of the second bus bars 112 and ends of the second finger electrodes 122 facing any of the first bus bars 111. The insulation portions 130 can prevent the finger electrodes 120 that are arranged on opposing sides of a bus bar 110, not in connection with the bus bar 110, and of a polarity different from that of the bus bar 110 from connecting with the corresponding welding strip and prevent the resulted short-circuit, which is conducive to improvement of the stability of the back contact photovoltaic module. The insulation portions 130 includes first insulation portions 131 and second insulation portions 132, the first insulation portions 131 are respectively arranged on opposing sides of the respective main body 114 along the first direction X, space apart from the respective main body 114, and are respectively arranged closest to the respective welding portions 113 in the second direction Y, and the second insulation portions 132 are respectively arranged on opposing sides of the respective main body 114 along the first direction X and space apart from the respective main body 114. In the first direction X, a first distance L1 between two first insulation portions of the first insulation portions 131 respectively arranged on opposing sides of the respective main body 114 is smaller than a second distance L2 between two second insulation portions of the second insulation portions 132 respectively arranged on opposing sides of the respective main body 114. In this way, the first distance L1 between two first insulation portions 131 along the first direction X is relatively small, such that the respective welding strip can fit in between the first insulation portions 131 along the second direction Y, thereby preventing the welding misalignment caused by offset of the respective welding strip during or after the welding. The second distance L2 between two second insulation portions 132 along the first direction X is relatively large, in this way, the second insulation portions 132 are not prone to move and cover the respective main body 114, resulting in failure in contact between the respective welding strip and the respective main body 114, thereby improving the contact reliability between the respective welding strip and the respective main body 114. The back contact photovoltaic module provided in the embodiments of the present disclosure can, on the one hand, improve the welding stability between the respective welding strip and the respective welding portions 113, and on the other hand, it can improve the contact reliability between the respective welding strip and the respective main body 114. In this way, the carrier transport efficiency can be comprehensively improved, power loss can be reduced, and the overall efficiency of the back contact photovoltaic module can be improved.

Referring to FIG. 1, the back contact photovoltaic module may further include a first connection wire 141 and a first traversing wire 143. The first connection wire 141 extends along the second direction Y and is arranged along a first edge of the respective solar cell 100. In the second direction Y, the first connection wire 141 is configured to be in electrical contact with a plurality of first finger electrodes 121 arranged at the first edge. The first traversing wire 143 extends along the first direction X and is arranged along a second edge of the respective solar cell 100. In the first direction X, the first traversing wire 143 is configured to be in electrical contact with ends of the first bus bars 111. An end of the first connection wire 141 is in electrical contact with an end of the first traversing wire 143. In this way, the plurality of first finger electrodes 121 arranged at the first edge of the respective solar cell 100 can be electrically contact to the first bus bars 111 via the first connection wire 141 and the first traversing wire 143, thereby achieving collection of the carriers on the plurality of first finger electrodes 121 arranged at the first edge of the respective solar cell 100.

Referring to FIG. 1, the back contact photovoltaic module may further include a second connection wire 142 and a second traversing wire 144. The second connection wire 142 extends along the second direction Y and is arranged along a third edge of the respective solar cell 100. In the second direction Y, the second connection wire 142 is configured to be in electrical contact with a plurality of second finger electrodes 122 arranged at the third edge. The second traversing wire 144 extends along the first direction X and is arranged along a fourth edge of the respective solar cell 100. In the first direction X, the second traversing wire 144 is configured to be in electrical contact with ends of the second bus bars 112. An end of the second connection wire 142 is in electrical contact with an end of the second traversing wire 144. In this way, the plurality of second finger electrodes 122 arranged at the third edge of the respective solar cell 100 can be electrically contact to the second bus bars 112 via the second connection wire 142 and the second traversing wire 144, thereby achieving collection of the carriers on the plurality of second finger electrodes 122 arranged at the third edge of the respective solar cell 100.

Referring to FIG. 1, taking an even number of the bus bars 110 being provided as an example, in this case, the polarity of the finger electrodes 120 arranged along the first edge is different from the polarity of the finger electrodes 120 arranged along the third edge of the respective solar cell 100. Thus, the first connection wire 141 arranged along the first edge and the second connection wire 142 arranged along the third edge are provided, and the first traversing wire 143 arranged along the second edge and the second traversing wire 144 arranged along the fourth edge are further provided. In some other embodiments, an odd number of the bus bars 110 may be provided. In this case, the polarity of the finger electrodes 120 arranged along the first edge is the same as the polarity of the finger electrodes 120 arranged along the third edge of the respective solar cell 100. Thus, the first connection wire arranged along the first edge and the second connection wire arranged along the third edge may be provided, and a first traversing wire arranged along at least one of the second edge and the fourth edge may be further provided.

In the accompanying drawings provided in the embodiments, the number of the finger electrodes 120 and the number of the bus bars 110 may be adjusted according to the actual situation, and do not constitute a limitation on the number of the finger electrodes 120 and the number of the bus bars 110 in the above embodiments. Correspondingly, the number of the welding portions 113 of each bus bar 110 may be adjusted according to the actual situation.

The back contact photovoltaic module may further include welding strips (not shown) configured for connecting the solar cells 100. Each welding strip of the welding strips is arranged on a respective bus bar of the plurality of bus bars 110 and is welded with welding portions 113 of the respective bus bar. In the first direction, a ratio of the first distance L1 to a width of a corresponding welding strip of the welding strips is in a range of 0.9 to 1.1, for example 0.9, 0.95, 1, 1.03, 1.06, 1.08, or 1.1. In other words, the first distance L1 between two first insulation portions 131 in the first direction is substantially equal to the width of a welding strip along the first direction. In this way, one respective welding strip can fit in between the first insulation portions 131, thereby preventing the welding misalignment caused by offset of the respective welding strip during or after the welding.

Referring to FIG. 2, in some embodiments, a respective plurality of pairs of second insulation portions 132 directly facing to each other are arranged between every two adjacent welding portions of the respective welding portions 113 along the second direction Y, each pair of second insulation portions of the respective plurality of pairs of second insulation portions 132 are configured to respectively cover two respective finger electrodes of the plurality of finger electrodes 120, and ends of the respective plurality of pairs of second insulation portions 132 form an ellipse-like space that tapers along the second direction Y. That is to say, for the second insulation portions 132 arranged between two adjacent welding portions 113 along the second direction Y, the further away from the two welding portions 113, the larger the second distance L2 between two second insulation portions 132 in the second direction Y. In this way, the second insulation portions 132 relatively close to the welding portions 113 can serve as an auxiliary fixation of the welding strip, thereby further improving the welding stability between the welding strips and the welding portions 113; and distances along the first direction between the second insulation portions 132 relatively far away from the welding portions 113 are relatively large, which is conducive to improvement of the contact reliability between the welding strips and the main bodies, thereby further improving the carrier transport efficiency, reducing power loss, and improving the overall efficiency of the back contact photovoltaic module.

FIG. 2 shows an example that for the plurality of pairs of second insulation portions 132 arranged between two adjacent welding portions 113 along the second direction Y, the second distance L2 along the first direction X between one respective pair of second insulation portions of the plurality of pairs of second insulation portions 132 is different from that between any pair of second insulation portions adjacent to the respective pair of second insulation portions along the second direction Y. That is to say, the second distance L2 varies in a continuous manner. In some other embodiments, the second distance L2 may vary in a stepped manner, for example, the distances L2 along the first direction X between every two, three, or four pairs of second insulation portions 132 that are adjacent to each other along the second direction Y may keep unchanged.

In some other embodiments, for the plurality of pairs of second insulation portions 132 arranged between two adjacent welding portions 113 along the second direction Y, the second distance L2 along the first direction X between each pair of second insulation portions of the plurality of pairs of second insulation portions 132 may keep unchanged.

Referring to FIG. 2, in some embodiments, the respective welding portions 113 include two outermost welding portions 113, a respective plurality of pairs of second insulation portions 132 directly facing to each other are arranged between each welding portion of the two outermost welding portions 113 and a corresponding edge of the respective solar cell 100 along the second direction Y, each pair of second insulation portions of the respective plurality of pairs of second insulation portions 132 are configured to respectively cover two respective finger electrodes of the plurality of finger electrodes 120, and a distance L2 between one respective pair of second insulation portions of the respective plurality of pairs of second insulation portions 132 along the first direction X gradually increases with a distance between the respective pair of second insulation portions 132 and any one of the two outermost welding portions 113 along the second direction Y. In other words, the further away from any one of the two outermost welding portions 113, the larger the second distance L2 between one respective pair of second insulation portions 132 along the first direction X. In this way, sufficient spaces can be left for the welding strips at the second and fourth edges of the respective solar cell 100, thereby preventing interference between the welding strips and the second insulation portions 132 from occurring at the second and fourth edges of the respective solar cell 100, such that the fragmentation of the solar cell 100 due to stress concentration can be prevented.

FIG. 2 shows an example that for the respective plurality of pairs of second insulation portions 132 arranged between each outermost welding portions 113 and a corresponding edge of the respective solar cell 100 along the second direction Y, the second distance L2 along the first direction X between one respective pair of second insulation portions 132 is different from that between any pair of second insulation portions adjacent to the respective pair of second insulation portions along the second direction Y. That is to say, the second distance L2 varies in a continuous manner. In some other embodiments, the second distance L2 may vary in a stepped manner, for example, the distances L2 along the first direction X between every two, three, or four pairs of second insulation portions 132 that are adjacent to each other along the second direction Y may keep unchanged.

In some other embodiments, for the respective plurality of pairs of second insulation portions 132 arranged between each outermost welding portions 113 and a corresponding edge of the respective solar cell 100 along the second direction Y, the second distance L2 along the first direction X between each pair of second insulation portions of the respective plurality of pairs of second insulation portions 132 may keep unchanged.

Referring to FIG. 2, the insulation portions 130 further include third insulation portions 133 respectively arranged on opposing sides of the respective welding portions 113 along the first direction X.

Referring to FIG. 2, in some embodiments, in the first direction X, a distance a between one respective third insulation portion of the third insulation portions 133 and a corresponding welding portion of the respective welding portions 113 is larger than a distance b between one respective first insulation portion of the first insulation portions 131 and the respective main body 114. When the distance between a third insulation portion 133 and a corresponding welding portion 113 along the first direction X is excessively small, during the welding process, the organic solvent in the third insulation portions 133 is prone to flow onto the welding portions 113, leading to abnormal solidification of the solder paste and a decrease in the welding tension between the welding strips and the welding portions 113. This problem can be addressed by increasing the distances between the third insulation portions 133 and the welding portions 113 along the first direction X, and the welding stability between the welding strips and the welding portions 113 can be improved.

In the first direction X, the distance between one respective third insulation portion of the third insulation portions 133 and a corresponding welding portion of the respective welding portions 113 may vary or keep unchanged, and the distance between one respective first insulation portion of the first insulation portions 131 and the respective main body 114 may vary or keep unchanged.

In some embodiments, in the first direction X, a distance between one respective third insulation portion of the third insulation portions 133 and a corresponding welding portion of the respective welding portions 113 is smaller than a distance between one respective first insulation portion of the first insulation portions 131 and the respective main body 114.

Referring to FIG. 2, in some embodiments, in the second direction Y, a distance c between one respective third insulation portion of the third insulation portions 133 and a finger electrode 120 adjacent to the respective third insulation portion is greater than a distance d between one respective first insulation portion of the first insulation portions 131 and a finger electrode 120 adjacent to the respective first insulation portion. When the distance between a third insulation portion 133 and an adjacent finger electrode 120 along the second direction Y is excessively small, during the welding process, the organic solvent in the third insulation portions 133 is prone to flow to the adjacent finger electrodes 120, and then flow onto the welding portions 113 along an extension direction of the adjacent finger electrodes 120, leading to abnormal solidification of the solder paste and a decrease in the welding tension between the welding strips and the welding portions 113. This problem can be addressed by increasing the distances between the third insulation portions 133 and the adjacent finger electrodes 120 along the second direction Y, and the welding stability between the welding strips and the welding portions 113 can be improved.

In the second direction Y, the distance between one respective third insulation portion of the third insulation portions 133 and a finger electrode 120 adjacent to the respective third insulation portion may vary or keep unchanged, and the distance between one respective first insulation portion of the first insulation portions 131 and a finger electrode 120 adjacent to the respective first insulation portion may vary or keep unchanged.

In some embodiments, the finger electrodes 120 are arranged at equal intervals along the second direction Y, and a width of one respective third insulation portion of the third insulation portions 133 in the second direction Y may be smaller than a width of one respective first insulation portion of the first insulation portions 131 in the second direction Y, such that the distance between the respective third insulation portion 133 and the finger electrode 120 adjacent to the respective third insulation portion is greater than the distance between the respective first insulation portion 131 and the finger electrode 120 adjacent to the respective first insulation portion. In some other embodiments, a width of one respective third insulation portion of the third insulation portions 133 in the second direction Y is equal to a width of one respective first insulation portion of the first insulation portions 131 in the second direction Y, and the distance between one respective third insulation portion of the third insulation portions 133 and a finger electrode 120 adjacent to the respective third insulation portion may be adjusted, such that the distance between the respective third insulation portion 133 and the finger electrode 120 adjacent to the respective third insulation portion is greater than the distance between the respective first insulation portion 131 and the finger electrode 120 adjacent to the respective first insulation portion.

In some embodiments, a length of one respective third insulation portion of the third insulation portions 133 in the first direction X may be equal to or not equal to a length of one respective first insulation portion of the first insulation portions 131 in the first direction X.

Referring to FIG. 2, in some embodiments, in the second direction Y, a distance d between one respective first insulation portion of the first insulation portions 131 and a finger electrode 120 adjacent to the respective first insulation portion is greater than a distance e between one respective second insulation portion of the second insulation portions 132 and a finger electrode 120 adjacent to the respective second insulation portion. Due to the fact that the first insulation portions 131 are respectively arranged closest to the welding portions 113 in the second direction Y, during the welding process, the organic solvent in the first insulation portions 131 is prone to flow to the adjacent finger electrodes 120, and then flow onto the welding portions 113 along an extension direction of the adjacent finger electrodes 120, leading to abnormal solidification of the solder paste and a decrease in the welding tension between the welding strips and the welding portions 113. This problem can be addressed by increasing the distances between the first insulation portions 131 and the adjacent finger electrodes 120 along the second direction Y, and the welding stability between the welding strips and the welding portions 113 can be improved.

In the second direction Y, the distance between one respective second insulation portion of the second insulation portions 132 and a finger electrode 120 adjacent to the respective second insulation portion may vary or keep unchanged.

In some embodiments, the finger electrodes 120 are arranged at equal intervals along the second direction Y, and a width of one respective first insulation portion of the first insulation portions 131 in the second direction Y may be smaller than a width of one respective second insulation portion of the second insulation portions 132 in the second direction Y, such that the distance between the respective first insulation portion 131 and the finger electrode 120 adjacent to the respective first insulation portion is greater than the distance between the respective second insulation portion 132 and the finger electrode 120 adjacent to the respective second insulation portion. In some other embodiments, a width of one respective first insulation portion of the first insulation portions 131 in the second direction Y is equal to a width of one respective second insulation portion of the second insulation portions 132 in the second direction Y, and the distance between one respective first insulation portion of the first insulation portions 131 and a finger electrode 120 adjacent to the respective first insulation portion 131 may be adjusted, such that the distance between the respective first insulation portion 131 and the finger electrode 120 adjacent to the respective first insulation portion is greater than the distance between the respective second insulation portion 132 and the finger electrode 120 adjacent to the respective second insulation portion.

In some embodiments, a length of one respective first insulation portion of the first insulation portions 131 in the first direction X may be equal to or not equal to a length of one respective second insulation portion of the second insulation portions 132 in the first direction X.

Referring to FIG. 2, in some embodiments, a distance f between an end of one respective first insulation portion of the first insulation portions 131 facing the respective main body 114 and an end of a finger electrode 120 covered by the respective first insulation portion 131 is greater than a distance g between an end of one respective third insulation portion of the third insulation portions 133 facing the respective welding portions 113 and an end of a finger electrode 120 covered by the respective third insulation portion 133. In this way, short circuiting with the finger electrodes 120 of the opposite polarity due to the offset of a welding strip towards both sides of the main body 114 can be prevented. Since the welding portions 113 are welded with the welding strip, the possibility of offset of the welding strip at the welding portions 113 is smaller than that of offset towards both sides of the main body 114. Therefore, the distance between an end of the respective third insulation portion 133 facing the respective welding portions 113 and an end of a finger electrode 120 covered by the respective third insulation portion 133 can be relatively small.

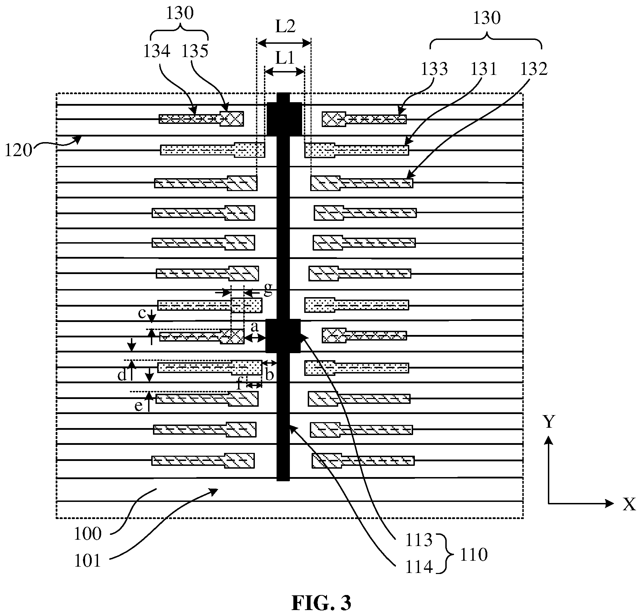

FIG. 3 is a schematic enlarged view of a local structure of a solar cell according to some embodiments of the present disclosure.

Referring to FIG. 3, in some embodiments, each insulation portion of the insulation portions 130 includes a respective body portion 134 and a respective widened portion 135 connected to each other, widened portions are configured to cover ends of the plurality of finger electrodes 120, and the respective body portion 134 is arranged on a side of the respective widened portion 135 away from an end of a finger electrode 120 covered by the respective widened portion 135. A width of the respective widened portion 135 along the second direction Y is greater than a width of the respective body portion 134 along the second direction Y. In other words, an end of one respective insulation portion 130 facing a corresponding bus bar 110 is configured as a widened portion 135. On the one hand, the widened portions 135 can further reduce the risk of short circuiting between the welding strips and the ends of the finger electrodes 120 of the opposite polarity, thereby improving the stability of the back contact photovoltaic module. On the other hand, the body portions 134 having smaller widths can reduce the cost of material of the insulation portions 130, thereby reducing the manufacturing cost of the back contact photovoltaic module.

When each insulation portion 130 includes a respective body portion 134 and a respective widened portion 135, in the second direction Y, the first distance L1 between two first insulation portions 131 is regarded as a distance between widened portions 135 of the two first insulation portions 131, and the second distance L2 between two second insulation portions 132 is regarded as a distance between widened portions 135 of the two second insulation portions 132.

When each insulation portion 130 includes a respective body portion 134 and a respective widened portion 135, in the first direction X, the distance a between one respective third insulation portion 133 and a corresponding welding portion 113 is regarded as a distance between a widened portion 135 of the respective third insulation portion 133 and the corresponding welding portion 113, and the distance b between one respective first insulation portion 131 and a corresponding main body 114 is regarded as a distance between a widened portion 135 of the respective first insulation portion 131 and the corresponding main body 114.

When each insulation portion 130 includes a respective body portion 134 and a respective widened portion 135, in the second direction Y, the distance c between one respective third insulation portion 133 and a finger electrode 120 adjacent to the respective third insulation portion 133 is regarded as a distance between a widened portion 135 of the respective third insulation portion 133 and the adjacent finger electrode 120, and the distance d between one respective first insulation portion 131 and a finger electrode 120 adjacent to the respective first insulation portion 131 is regarded as a distance between a widened portion 135 of the respective first insulation portion 131 and the adjacent finger electrode 120.

When each insulation portion 130 includes a respective body portion 134 and a respective widened portion 135, in the second direction Y, the distance e between one respective second insulation portion 132 and a finger electrode 120 adjacent to the respective second insulation portion 132 is regarded as a distance between a widened portion 135 of the respective second insulation portion 132 and the adjacent finger electrode 120.

When each insulation portion 130 includes a respective body portion 134 and a respective widened portion 135, the distance f between an end of one respective first insulation portion 131 facing the respective main body 114 and an end of a finger electrode 120 covered by the respective first insulation portion 131 is regarded as a distance between an end of a widened portion 135 of the respective first insulation portion 131 facing the respective main body 114 and the end of the finger electrode 120 covered by the widened portion 135 of the respective first insulation portion 131, and the distance g between an end of one respective third insulation portion 133 facing the respective welding portions 113 and an end of a finger electrode 120 covered by the respective third insulation portion 133 is regarded as a distance between an end of a widened portion 135 of the respective third insulation portion 133 facing the respective welding portions 113 and the end of the finger electrode 120 covered by the widened portion 135 of the respective third insulation portion 133.

In some embodiments, a length of a widened portion 135 of one respective third insulation portion of the third insulation portions 133 along the first direction X is less than a length of a widened portion 135 of one respective first insulation portion of the first insulation portions 131. Since the welding portions 113 are welded with the welding strip, the possibility of offset of the welding strip at the welding portions 113 is smaller than that of offset towards both sides of the main body 114. Therefore, the length of a widened portion 135 of one respective third insulation portion 133 along the first direction X is less than the length of a widened portion 135 of one respective first insulation portion 131, in this way, the risk of short circuiting between the welding strips and the ends of the finger electrodes 120 of the opposite polarities can be reduced, and the manufacturing cost of the insulation portions can also be reduced.

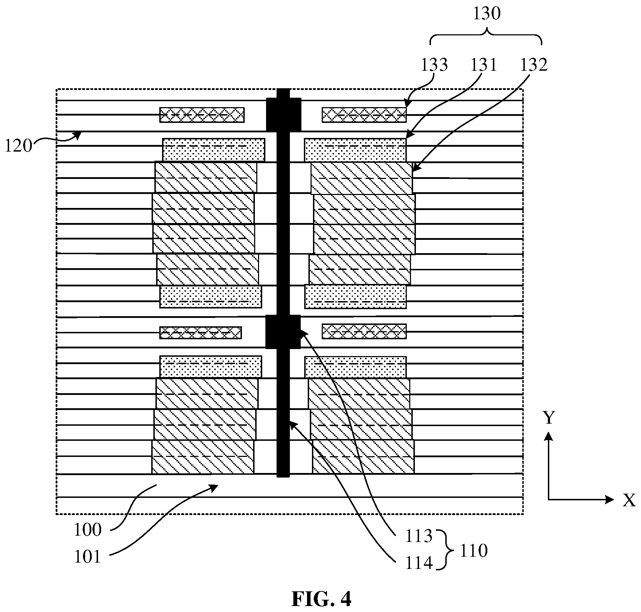

FIG. 4 is a schematic enlarged view of a local structure of another solar cell according to some embodiments of the present disclosure.

Referring to FIG. 4, in some embodiments, first insulation portions 131 and second insulation portions 132 arranged on a same side of the respective main body 114 are integrally formed as a whole. It is necessary for the first insulation portions 131 and the third insulation portions 133 arranged close to the welding portions 113 to be spaced apart from the finger electrodes 120 connecting to the welding portions 113, in order to prevent the organic solvents in the first insulation portions 131 or the third insulation portions 133 from spreading along the finger electrodes 120 to the welding portions 113, thereby preventing abnormal solidification of solder paste. The second insulation portions 132 are relatively far away from the welding portions 113, and the organic solvents are not prone to flow to the welding portions 113. Thus, integrally forming the first insulation portions 131 and the second insulation portions 132 arranged on a same side of the respective main body 114 can facilitate the integrated printing of the first insulation portions 131 and the second insulation portions 132, thereby improving the manufacturing efficiency of the back contact photovoltaic module.

In some embodiments, in a direction perpendicular to the first surface 101, one respective first insulation portion of the first insulation portions 131 has a height larger than a height of one respective bus bar of the plurality of bus bars 110. In this way, after welding one respective welding strip, the first insulation portions 131 can abut the respective welding strip on opposing sides, thereby keeping the relative position of the respective welding strip and improving stability of the respective welding strip during or after welding.

Referring to FIG. 4, when each first insulation portion of the first insulation portions 131 includes a respective body portion 134 and a respective widened portion 135, in a direction perpendicular to the first surface 101, the respective widened portion 135 may have a height larger than a height of the respective body portion 134 and a height of one respective bus bar of the plurality of bus bars 110. In this way, on the one hand, after welding one respective welding strip, the first insulation portions 131 can abut the respective welding strip on opposing sides, thereby keeping the relative position of the respective welding strip and improving stability of the respective welding strip during or after welding; and on the other hand, the widened portions 135 having relatively large heights can prevent exposure of the ends of the finger electrodes 120 due to shrinkage of the insulation portions 130 after solidification.

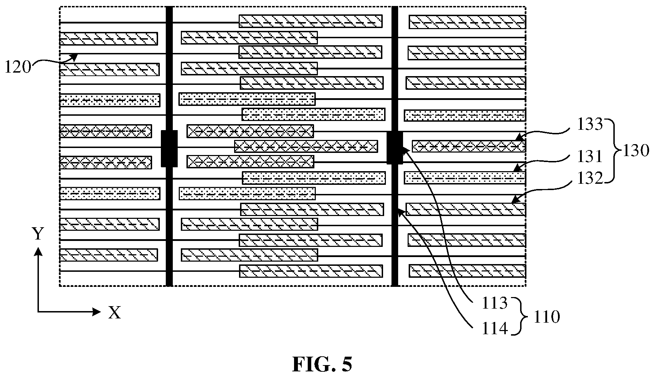

FIG. 5 is a schematic enlarged view of a local structure of still another solar cell according to some embodiments of the present disclosure.

Referring to FIG. 5, in some embodiments, in the first direction X, one respective insulation portion of the insulation portions 130 may have a length less than a distance between two adjacent bus bar of the plurality of bus bars 110 and larger than a half of the distance. In this way, the insulation portions 130 cover relatively large portions of the plurality of finger electrodes 120, thereby further reducing the risk of short circuiting between the welding strips and the ends of the finger electrodes 120 of the opposite polarities.

In some embodiments, referring to FIGS. 3 and 5, when each insulation portion of the insulation portions 130 includes a respective body portion 134 and a respective widened portion 135, in the first direction X, the respective body portion 134 may have a length less than a distance between two adjacent bus bar of the plurality of bus bars 110 and larger than a half of the distance. In this way, the risk of short circuiting between the welding strips and the ends of the finger electrodes 120 of the opposite polarities can be further reduced.

In some embodiments, the solar cell 100 may be an IBC (interdigitated back contact) cell, an HPBC (hybrid passivated back contact) cell, a TBC cell including TOPCon (tunnel oxide passivated contact) technology and IBC technology, or an HBC cell including HIT/HJT (heterojunction technology) and IBC technology. Of course, the solar cell 100 may also be a back contact solar cell of other types.

In some embodiments, the solar cell 100 may be a monocrystalline silicon solar cell, a polycrystalline silicon solar cell, an amorphous silicon solar cell, or a multicomponent compound solar cell. The multicomponent compound solar cell may be a cadmium sulfide solar cell, a gallium arsenide solar cell, a copper indium selenide solar cell, or a perovskite solar cell.

In some embodiments, the back contact photovoltaic module further includes at least one encapsulation layer that covers at least one surface of the solar cell. The material of the at least one encapsulation layer may be organic encapsulation films such as ethylene vinyl acetate copolymer (EVA) film, polyethylene octene elastomer (POE) film, polyvinyl butyraldehyde ester (PVB) film, or the like.

In some embodiments, the back contact photovoltaic module further includes at least one cover plate arranged on the surface of the at least one encapsulation layer away from the solar cell. The at least one cover plate may be made of a transparent material such as glass, plastic, or the like. In some embodiments, the surface of the at least one cover plate facing the at least one encapsulation layer may be a textured surface, thereby increasing the utilization rate of incident light.

In the back contact photovoltaic module provided in the embodiments of the present disclosure, a plurality of bus bars 110 and a plurality of finger electrodes 120 are formed on the surface of one respective solar cell 100, the plurality of finger electrodes 120 includes first finger electrodes 121 and second finger electrodes 122, and the first finger electrodes 121 are of a polarity that is different from a polarity of the second finger electrodes 122. The first finger electrodes 121 can collect one of electrons or holes in the respective solar cell 100, and the second finger electrodes 122 can collect the other of electrons or holes in the respective solar cell 100. The plurality of bus bars 110 includes first bus bars 111 and second bus bars 112, each first bus bar 111 is in electrical contact with a respective plurality of first finger electrodes of the first finger electrodes 121, and each second bus bar 112 is in electrical contact with a respective plurality of second finger electrodes of the second finger electrodes 122. In this way, the first bus bars 111 can collect the carriers collected by the first finger electrodes 121 arranged along the second direction Y, and the second bus bars 112 can collect the carriers collected by the second finger electrodes 122 arranged along the second direction Y. Each bus bar 110 includes a respective main body 114 and respective welding portions 113 formed at intervals on the respective main body, and each welding portion 113 has a dimension larger than a dimension of the respective main body 114 in the first direction X. In this way, when arranging a respective welding strip on each bus bar 110, the respective welding portions 113 can have larger contact areas with the respective welding strip compared to the respective main body 114, thereby improving the welding stability between each bus bar 110 and the respective welding strip. The insulation portions 130 are configured to cover ends of the first finger electrodes 121 facing any of the second bus bars 112 and ends of the second finger electrodes 122 facing any of the first bus bars 111. The insulation portions 130 can prevent the finger electrodes 120 that are arranged on opposing sides of a bus bar 110, not in connection with the bus bar 110, and of a polarity different from that of the bus bar 110 from connecting with the corresponding welding strip and prevent the resulted short-circuit, which is conducive to improvement of the stability of the back contact photovoltaic module. The insulation portions 130 includes first insulation portions 131 and second insulation portions 132, the first insulation portions 131 are respectively arranged on opposing sides of the main body 114 of a respective bus bar 110 in the first direction X, and are respectively arranged to adjacent to the welding portions 113 of the respective bus bar 110 in the second direction Y, and the second insulation portions 132 are respectively arranged on opposing sides of the main body 114 of the respective bus bar 110 and space apart from the main body 114 of the respective bus bar 110 in the first direction X. In the first direction X, two first insulation portions of the first insulation portions 131 respectively arranged on opposing sides of the main body 114 of the respective bus bar 110 are spaced apart by a first distance L1, and two second insulation portions of the second insulation portions 132 respectively arranged on opposing sides of the main body 114 of the respective bus bar 110 are spaced apart by a second distance L2 that is greater than the first distance L1. In this way, the first distance L1 between two first insulation portions 131 along the first direction X is relatively small, such that the respective welding strip can fit in between the first insulation portions 131 along the second direction Y, thereby preventing the welding misalignment caused by offset of the respective welding strip during or after the welding. The second distance L2 between two second insulation portions 132 along the first direction X is relatively large, in this way, the second insulation portions 132 are not prone to move and cover the respective main body 114, resulting in failure in contact between the respective welding strip and the respective main body 114, thereby improving the contact reliability between the respective welding strip and the respective main body 114. The back contact photovoltaic module provided in the embodiments of the present disclosure can, on the one hand, improve the welding stability between the respective welding strip and the respective welding portions 113, and on the other hand, it can improve the contact reliability between the respective welding strip and the respective main body 114. In this way, the carrier transport efficiency can be comprehensively improved, power loss can be reduced, and the overall efficiency of the back contact photovoltaic module can be improved.

Those skilled in the art shall understand that the above-mentioned embodiments are specific examples for implementing the present disclosure. In practice, various changes may be made in form and details without departing from the scope of the present disclosure. Therefore, the patent scope of protection of the present disclosure shall be subject to the scope limited by the appended claims.

## Claims

1. A back contact photovoltaic module, comprising:
solar cells (100), wherein one respective solar cell of the solar cells (100) includes a first surface (101), a plurality of bus bars (110) and a plurality of finger electrodes (120) formed on the first surface (101); and
insulation portions (130) arranged on the first surface (101);
wherein the plurality of finger electrodes (120) include first finger electrodes (121) and second finger electrodes (122) extending along a first direction (X) and alternatingly arranged along a second direction (Y), the first direction (X) intersecting the second direction (Y), and the first finger electrodes (121) are of a polarity that is different from a polarity of the second finger electrodes (122);
wherein the plurality of bus bars (110) include first bus bars (111) and second bus bars (112) extending along the second direction (Y) and alternatingly arranged along the first direction (X), each first bus bar of the first bus bars (111) is in electrical contact with a respective plurality of first finger electrodes of the first finger electrodes (121), and each second bus bar of the second bus bars (112) is in electrical contact with a respective plurality of second finger electrodes of the second finger electrodes (122);
wherein each bus bar of the plurality of bus bars (110) includes a respective main body (114) extending along the second direction (Y) and respective welding portions (113) formed at intervals on the respective main body (114), and each welding portion of the respective welding portions (113) has a dimension larger than a dimension of the respective main body (114) in the first direction (X);
wherein the insulation portions (130) are configured to cover at least ends of the first finger electrodes (121) facing any of the second bus bars (112) and ends of the second finger electrodes (122) facing any of the first bus bars (111), the insulation portions (130) includes first insulation portions (131) and second insulation portions (132), the first insulation portions (131) are respectively arranged on opposing sides of the main body (114) of a respective bus bar (110) in the first direction (X), and are respectively arranged to adjacent to the welding portions (113) of the respective bus bar (110) in the second direction (Y), and the second insulation portions (132) are respectively arranged on opposing sides of the main body (114) of the respective bus bar (110) and space apart from the main body (114) of the respective bus bar (110) in the first direction (X); and
wherein in the first direction (X), two first insulation portions of the first insulation portions (131) respectively arranged on opposing sides of the main body (114) of the respective bus bar (110) are spaced apart by a first distance (L1), and two second insulation portions of the second insulation portions (132) respectively arranged on opposing sides of the main body (114) of the respective bus bar (110) are spaced apart by a second distance (L2) that is greater than the first distance (L1).

2. The back contact photovoltaic module according to claim 1, wherein a respective plurality of pairs of second insulation portions (132) directly facing to each other are arranged between every two adjacent welding portions of the welding portions (113) of the respective bus bar (110) along the second direction (Y), each pair of second insulation portions of the respective plurality of pairs of second insulation portions (132) are configured to respectively cover two respective finger electrodes of the plurality of finger electrodes (120), and ends of the respective plurality of pairs of second insulation portions (132) form an ellipse-like space that tapers along the second direction (Y).

3. The back contact photovoltaic module according to claim 1 or claim 2, wherein the welding portions (113) of the respective bus bar (110) include two outermost welding portions (113), a respective plurality of pairs of second insulation portions (132) directly facing to each other are arranged between each welding portion of the two outermost welding portions (113) and a corresponding edge of the respective solar cell (100) along the second direction (Y), each pair of second insulation portions of the respective plurality of pairs of second insulation portions (132) are configured to respectively cover two respective finger electrodes of the plurality of finger electrodes (120), and a distance between one respective pair of second insulation portions of the respective plurality of pairs of second insulation portions (132) along the first direction (X) gradually increases with a distance between the respective pair of second insulation portions and any one of the two outermost welding portions (113) along the second direction (Y).

4. The back contact photovoltaic module according to any one of claims 1 to 3, wherein the insulation portions (130) further include third insulation portions (133) respectively arranged on opposing sides of the welding portions (113) of the respective bus bar (110) in the first direction (X), and in the first direction (X), one respective third insulation portion of the third insulation portions (133) and a corresponding welding portion of the welding portions (113) of the respective bus bar (110) are spaced apart by a distance larger than a distance between one respective first insulation portion of the first insulation portions (131) and the main body (114) of the respective bus bar (110).

5. The back contact photovoltaic module according to any one of claims 1 to 4, wherein the insulation portions (130) further include third insulation portions (133) respectively arranged on opposing sides of the welding portions (113) of the respective bus bar (110) in the first direction (X), and in the second direction (Y), one respective third insulation portion of the third insulation portions (133) and a finger electrode (120) adjacent to the respective third insulation portion are spaced apart by a distance greater than a distance between one respective first insulation portion of the first insulation portions (131) and a finger electrode (120) adjacent to the respective first insulation portion.

6. The back contact photovoltaic module according to claim 5, wherein in the second direction (Y), one respective first insulation portion of the first insulation portions (131) and a finger electrode (120) adjacent to the respective first insulation portion are spaced apart by a distance greater than a distance between one respective second insulation portion of the second insulation portions (132) and a finger electrode (120) adjacent to the respective second insulation portion.

7. The back contact photovoltaic module according to any one of claims 1 to 6, wherein the insulation portions (130) further include third insulation portions (133) respectively arranged on opposing sides of the welding portions (113) of the respective bus bar (110) in the first direction (X), and an end of one respective first insulation portion of the first insulation portions (131) facing the main body (114) of the respective bus bar (110) and an end of a finger electrode (120) covered by the respective first insulation portion are spaced apart by a distance greater than a distance between an end of one respective third insulation portion of the third insulation portions (133) facing a corresponding welding portion (113) and an end of a finger electrode (120) covered by the respective third insulation portion.

8. The back contact photovoltaic module according to any one of claims 1 to 7, wherein each insulation portion of the insulation portions (130) includes a respective body portion (134) and a respective widened portion (135) connected to each other, widened portions (135) are configured to cover ends of the plurality of finger electrodes (120), and the respective body portion (134) is arranged on a side of the respective widened portion (135) away from an end of a finger electrode (120) covered by the respective widened portion (135); and
a width of the respective widened portion (135) along the second direction (Y) is greater than a width of the respective body portion (134) along the second direction (Y).

9. The back contact photovoltaic module according to claim 8, wherein the insulation portions (130) further include third insulation portions (133) respectively arranged on opposing sides of the welding portions (113) of the respective bus bar (110) in the first direction (X), and a widened portion (135) of one respective third insulation portion of the third insulation portions (133) along the first direction (X) has a length less than a length of a widened portion (135) of one respective first insulation portion of the first insulation portions (131).

10. The back contact photovoltaic module according to any one of claims 1 to 9, further including:
welding strips configured for connecting the solar cells (100), wherein each welding strip of the welding strips is arranged on a respective bus bar of the plurality of bus bars (110) and is welded with welding portions (113) of the respective bus bar (110), and in the first direction (X), a ratio of the first distance (L1) to a width of a corresponding welding strip of the welding strips is in a range of 0.9 to 1.1.

11. The back contact photovoltaic module according to any one of claims 1 to 10, further including:
a first connection wire (141) and a first traversing wire (143);
wherein the first connection wire (141) extends along the second direction (Y) and is arranged along a first edge of the respective solar cell, and in the second direction (Y), the first connection wire (141) is configured to be in electrical contact with a plurality of first finger electrodes of the first finger electrodes (121) arranged at the first edge;
wherein the first traversing wire (143) extends along the first direction (X) and is arranged along a second edge of the respective solar cell, and in the first direction (X), the first traversing wire (143) is configured to be in electrical contact with ends of the first bus bars (111); and
wherein an end of the first connection wire (141) is in electrical contact with an end of the first traversing wire (143).

12. The back contact photovoltaic module according to any one of claims 1 to 11, further including:
a second connection wire (142) and a second traversing wire (144);
wherein the second connection wire (142) extends along the second direction (Y) and is arranged along a third edge of the respective solar cell, and in the second direction (Y), the second connection wire (142) is configured to be in electrical contact with a plurality of second finger electrodes of the second finger electrodes (122) arranged at the third edge;
wherein the second traversing wire (144) extends along the first direction (X) and is arranged along a fourth edge of the respective solar cell, and in the first direction (X), the second traversing wire (144) is configured to be in electrical contact with ends of the second bus bars (112); and
wherein an end of the second connection wire (142) is in electrical contact with an end of the second traversing wire (144).

13. The back contact photovoltaic module according to any one of claims 1 to 12, wherein in a direction perpendicular to the first surface (101), one respective first insulation portion of the first insulation portions (131) has a height larger than a height of one respective bus bar of the plurality of bus bars (110).

14. The back contact photovoltaic module according to claim 1, wherein a plurality of first insulation portions of the first insulation portions (131) and a plurality of second insulation portions of the second insulation portions (132) that are arranged on a same side of the main body (114) of the respective bus bar (110) are integrally formed as a whole.

15. The back contact photovoltaic module according to any one of claims 1 to 14, wherein in the first direction (X), one respective insulation portion of the insulation portions (130) has a length less than a third distance between two adjacent bus bar of the plurality of bus bars (110) and larger than a half of the third distance.
